Europäisches Patentamt

European Patent Office

Office européen des brevets

(19)

(11) **EP 0 700 162 B1**

(12) **FASCICULE DE BREVET EUROPEEN**

(45) Date de publication et mention
de la délivrance du brevet:
**12.05.1999 Bulletin 1999/19**

(51) Int Cl.$^6$: **H03K 19/0944**, H03K 17/62,
H03K 19/00

(21) Numéro de dépôt: **95410089.7**

(22) Date de dépôt: **28.08.1995**

(54) **Circuit logique à étages différentiels**

Logische Schaltung mit Differenzstufen

Logic circuit with differential stages

(84) Etats contractants désignés:
**DE FR GB IT**

(30) Priorité: **31.08.1994 FR 9410633**

(43) Date de publication de la demande:
**06.03.1996 Bulletin 1996/10**

(73) Titulaire: **STMicroelectronics S.A.**
**94250 Gentilly (FR)**

(72) Inventeurs:
• **Bernard, Patrick**
**F-38320 Poisat (FR)**
• **Belot, Didier**
**F-38140 Rives (FR)**
• **Quervel, Jacques**
**F-38330 Montbonnot Saint Martin (FR)**

(74) Mandataire: **de Beaumont, Michel**
**1bis, rue Champollion**
**38000 Grenoble (FR)**

(56) Documents cités:
**EP-A- 0 326 897          US-A- 5 124 588**
**US-A- 5 287 016**

• **PATENT ABSTRACTS OF JAPAN vol. 16 no. 288
(E [1223] ,25 Juin 1992 & JP-A-04 072916
(HITACHI) 6 Mars 1992,**

**Description**

La présente invention concerne les circuits logiques du type comprenant des étages différentiels fonctionnant en régime linéaire, tels que les circuits logiques à émetteurs couplés (ECL).

Les circuits ECL sont parmi les circuits logiques les plus rapides. Pour atteindre une vitesse de fonctionnement élevée, ces circuits sont conçus de manière que leurs transistors, bipolaires, n'entrent jamais en régime de saturation. Un transistor bipolaire entre en régime de saturation lorsque sa tension collecteur-émetteur Vce est inférieure à sa tension base-émetteur Vbe. Dans ce cas, la base présente une capacité notablement plus élevée que lorsque le transistor est en régime linéaire, ce qui est à l'origine de la lenteur des circuits logiques bipolaires classiques. Pour éviter la saturation des transistors, ils sont montés en étages différentiels, c'est pourquoi on utilise la terminologie "émetteurs couplés". Ainsi, les signaux traités par les circuits ECL sont le plus souvent différentiels et chaque composante d'un signal différentiel est appliquée à une entrée respective d'un étage différentiel.

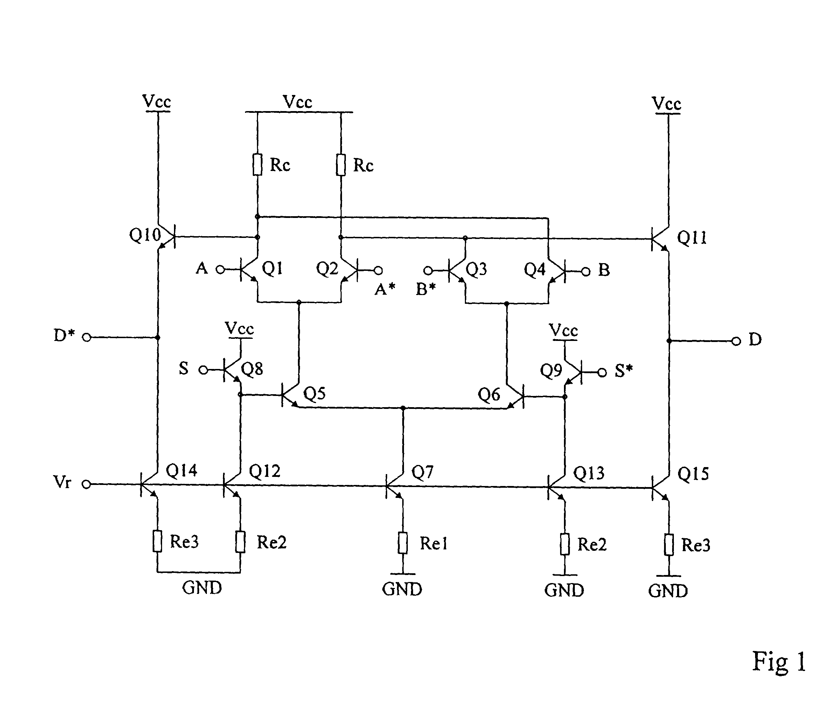

La figure 1 représente un exemple de circuit ECL classique, un multiplexeur dans ce cas. Tous les transistors de ce circuit sont bipolaires du type NPN. Un premier signal complémentaire A/A* est appliqué sur les entrées d'un premier étage différentiel constitué d'un couple de transistors Q1 et Q2. Les collecteurs des transistors Q1 et Q2 sont reliés à un potentiel d'alimentation haut Vcc par des résistances respectives Rc. On dira que les résistances Rc sont montées dans les branches de l'étage différentiel Q1, Q2. Un deuxième signal différentiel B/B* est appliqué aux entrées d'un étage différentiel constitué d'un couple de transistors Q3 et Q4. Les deux branches de cet étage Q3, Q4 sont respectivement reliées aux branches de l'étage Q1, Q2.

Les étages Q1, Q2 et Q3, Q4 sont montés respectivement dans les branches d'un étage différentiel constitué d'un couple de transistors Q5, Q6, c'est-à-dire que le collecteur du transistor Q5 est relié aux émetteurs des transistors Q1 et Q2, et que le collecteur du transistor Q6 est relié aux émetteurs des transistors Q3 et Q4. L'étage Q5, Q6 est polarisé par une source de courant constituée d'un transistor Q7 dont l'émetteur est relié à un potentiel d'alimentation bas GND (la masse) par une résistance Rel, et dont le collecteur est relié aux émetteurs des transistors Q5 et Q6. Une tension de référence Vr appliquée sur la base du transistor Q7 détermine le courant de polarisation de l'étage Q5, Q6. Un signal de sélection différentiel S/S* est appliqué aux entrées de l'étage Q5, Q6 par l'intermédiaire de transistors montés en suiveur Q8, Q9.

La sortie du circuit logique est un signal différentiel D/D* prélevé sur les branches de l'étage Q1, Q2 par des transistors montés en suiveur Q10 et Q11.

Les transistors suiveurs Q8 à Q11 sont polarisés respectivement par des transistors Q12 à Q15 reliés à des résistances d'émetteur (Re2 pour les transistors Q12, Q13, et Re3 pour les transistors Q14, Q15) comme le transistor Q7.

Le fonctionnement de ce multiplexeur est en bref le suivant. Si le signal différentiel S/S* est à l'état haut (c'est-à-dire que les composantes S et S* sont respectivement aux états haut et bas), le transistor Q5 est passant et le transistor Q6 est bloqué. L'étage Q3, Q4 est alors inactif et seul l'étage Q1, Q2 impose la valeur du signal A/A* sur la sortie D/D*. Inversement, si le signal S/S* est à l'état bas, c'est le signal B/B* qui est présent sur la sortie D/D*.

Les transistors suiveurs Q8 et Q9 sont nécessaires pour éviter la saturation des transistors Q5 et Q6. En effet, par exemple, si les composantes A et S sont au même état, les tensions de collecteur et de base du transistor Q5 sont égales, ce qui garantit que la tension collecteur-émetteur du transistor Q5 est au moins égale à la tension base-émetteur Vbe de ce transistor. En l'absence du transistor suiveur Q8, la tension collecteur-émetteur du transistor Q5 serait pratiquement nulle, entraînant la saturation de ce transistor Q5.

Les signaux ECL ont une faible excursion, c'est-à-dire que la différence de potentiel entre l'état haut et l'état bas d'une composante d'un signal ECL est faible. Cette faible excursion, de l'ordre de 0,5 volt, contribue à augmenter la rapidité du circuit logique en diminuant l'énergie de charge et de décharge de capacités parasites.

Pour connaître l'évolution d'un signal ECL, on considère, par exemple, la tension d'émetteur (D*) du transistor Q10. Si les transistors Q1 et Q4 sont bloqués, cette tension est pratiquement égale à Vcc-Vbe. Si les transistors Q1 et Q5 sont conducteurs, cette tension chute d'une valeur Vs, correspondant à l'excursion, égale au produit du courant du transistor Q7 par la valeur de la résistance Rc. Ainsi, la tension sur la sortie D* varie entre Vcc-Vbe et Vcc-Vbe-Vs. Le circuit de la figure 1 est destiné à être connecté par l'une de ses entrées (A/A*, B/B*, S/S*) à la sortie (D/D*) d'un autre circuit similaire. L'excursion Vs étant fixée (environ 0,5 volt), la tension Vcc doit être suffisamment élevée pour que la valeur minimale de la sortie de l'autre circuit n'entraîne pas la saturation des transistors Q1, Q5, Q7 ou Q8, Q5, Q7, par exemple. Ainsi, la tension minimale de la sortie D* est égale à la somme de trois tensions Vbe (des transistors Q1 ou Q8, et Q5 et Q7 par exemple) et d'une tension Vr-Vbe apparaissant aux bornes de la résistance d'émetteur Re du transistor Q7. Cette tension minimale est donc 2Vbe+Vr. Par conséquent, la tension d'alimentation Vcc doit être telle que

$$Vcc-Vbe-Vs > 2Vbe+Vr.$$

Pour des valeurs typiques Vs=0,5, Vbe=0,9, Vr=1,2, la tension Vcc doit au moins être égale à 4,4 volts. Un circuit ECL est typiquement alimenté sous 5 volts.

Un inconvénient des circuits ECL est leur importante consommation de courant due au fait que les courants délivrés par les sources de courant sont toujours consommés par des transistors suiveurs ou l'une ou l'autre branche d'un étage différentiel. Si l'on parvenait à réduire la tension d'alimentation Vcc, la consommation de courant serait réduite dans les mêmes proportions.

Un objet de la présente invention est de réaliser un circuit logique à étages différentiels dont la tension d'alimentation peut être particulièrement faible.

Un autre objet de la présente invention est de réaliser un tel circuit logique consommant un courant particulièrement faible.

Ces objets sont atteints selon l'invention en remplaçant des transistors bipolaires particuliers du circuit logique par des transistors MOS.

L'invention concerne plus particulièrement un circuit logique, de type connu de JP-A-4 072 916, qui comprend au moins un premier étage différentiel réalisé à partir de transistors bipolaires fonctionnant en régime linéaire, monté dans une branche d'un deuxième étage différentiel polarisé par une source de courant, dans lequel le deuxième étage et la source de courant sont réalisés à partir de transistors MOS.

Selon un mode de réalisation de la présente invention, les grilles des transistors MOS du deuxième étage constituent directement des entrées du circuit logique.

Selon un mode de réalisation de la présente invention, la source de courant est réalisée à partir d'un transistor MOS dont la source est directement reliée à un potentiel d'alimentation.

Un multiplexeur selon l'invention comprend deux premiers étages dont les branches correspondantes sont reliées entre elles, ces deux étages étant respectivement montés dans les branches du deuxième étage.

Une porte logique selon l'invention comprend un premier étage monté dans une première branche du deuxième étage, la deuxième branche du deuxième étage étant reliée à une branche du premier étage.

Selon un mode de réalisation de la présente invention, les transistors bipolaires sont de type NPN et les transistors MOS sont à canal N.

Ces objets, caractéristiques et avantages ainsi que d'autres de la présente invention seront exposés plus en détail dans la description suivante de modes de réalisation particuliers faite à titre non-limitatif à l'aide des figures jointes parmi lesquelles :

la figure 1, précédemment décrite, représente un circuit ECL classique ;
la figure 2 représente un exemple de circuit logique à étages différentiels selon l'invention ; et
la figure 3 représente un autre exemple de circuit logique selon l'invention.

Un circuit logique à étages différentiels selon l'invention comprend, de façon générale, un premier niveau d'étages différentiels constitués de transistors bipolaires NPN. Un deuxième niveau d'étages différentiels, comprenant dans leurs branches des étages différentiels du premier niveau, est, au contraire, constitué de transistors MOS à canal N. De même, les sources de courant de polarisation des étages du deuxième niveau et de transistors suiveurs sont également constituées de transistors MOS à canal N.

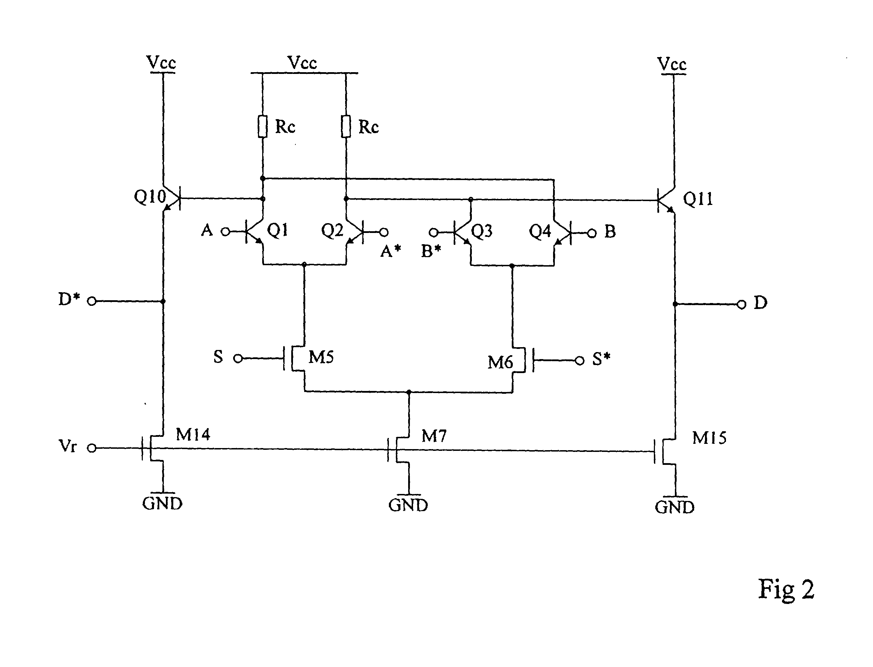

La figure 2 illustre un exemple de circuit logique ainsi réalisé selon l'invention. Le circuit de la figure 2 est un multiplexeur du même type que celui de la figure 1 et des mêmes éléments sont désignés par des mêmes références. L'étage différentiel Q5, Q6 de la figure 1 est remplacé dans la figure 2 par un étage différentiel à transistors MOS M5 et M6. De même, les sources de courant constituées des transistors Q7, Q14 et Q15 ainsi que les résistances d'émetteur associées Re de la figure 1 sont remplacés par des transistors MOS M7, M14 et M15, directement reliés à la masse GND. En outre, il s'avère que l'étage M5, M6 peut directement recevoir le signal différentiel S/S∗, sans qu'il soit nécessaire de prévoir des transistors suiveurs et des sources de polarisation correspondantes (Q8, Q9, Q12 et Q13 dans la figure 1). La consommation de courant du circuit est donc réduite par l'omission d'autant de couples de sources de polarisation que d'étages différentiels à transistors MOS.

La tension seuil grille-source Vt d'un transistor MOS joue le même rôle que la tension base-émetteur Vbe d'un transistor bipolaire. Ainsi, on pourrait croire, d'après les calculs effectués pour le circuit de la figure 1, que la tension Vcc minimale est 2Vt+2Vbe+Vs. Cette valeur serait supérieure à la tension Vcc minimale calculée pour le circuit de la figure 1 (avec les valeurs typiques Vs=0,5, Vbe=0,9, et Vt=1,2). Toutefois, un aspect de l'invention est de constater qu'il n'est pas gênant que la tension drain-source d'un transistor MOS soit inférieure à la tension seuil Vt. En effet, la capacité de grille du transistor MOS ne varie pas. La seule différence, non gênante, est que le transistor MOS se met à fonctionner en régime résistif, où la résistance drain-source varie en fonction de la tension grille-source. En pratique, cette tension drain-source en régime résistif, notée Von, ne dépasse pas 0,3 volt.

Ainsi, la tension Vcc minimale s'exprime par 2Vbe+2Von+Vs qui est de l'ordre de 2,9 volts avec les valeurs susmentionnées. Un circuit logique selon l'invention convient particulièrement bien à une intégration en technologie 0,7 micron qui admet une tension d'alimentation de l'ordre de 3,3 V.

On doit également calculer la tension Vcc minimale par rapport à la tension à appliquer aux grilles des transistors M5 et M6. Cette tension minimale s'exprime alors par Vbe+Vt+Von, où Vt est la tension seuil des transistors M5 et M6 et Von la tension drain-source du transistor M7. Cette tension Vcc minimale est sensiblement égale à celle précédemment calculée, car la tension Vt est sensiblement égale à Von+Vbe.

Il est inutile de faire précéder les transistors M5 et M6 de transistors suiveurs comme dans la figure 1. En effet, par exemple, si les composantes A et S sont au même potentiel, la tension drain-source du transistor M5 est égale à Vt-Vbe, c'est-à-dire environ Von.

En outre, il est inutile de munir les transistors M7, M14 et M15 de résistances de source. Dans la figure 1, des résistances d'émetteur étaient prévues pour compenser des différences entre les tensions base-émetteur des transistors et des chutes de tension entre les émetteurs provoquées par des courants relativement importants circulant dans les conducteurs reliant les émetteurs. Un transistor bipolaire a une transconductance importante et, en l'absence de résistances d'émetteur, une faible différence entre les tensions base-émetteur de deux des transistors des sources de courant provoquerait une notable différence entre les courants de collecteur de ces transistors. Par contre, un transistor MOS a une faible transconductance qui rend inutile de prévoir des résistances de source.

Bien entendu, du fait que les transistors MOS ont une plus faible transconductance que les transistors bipolaires, la taille des transistors M5 et M6 doit être relativement importante pour que la transconductance de ces transistors MOS soit du même ordre de grandeur que celle des transistors bipolaires Q5 et Q6 de la figure 1. Cette augmentation de taille n'est pas gênante car elle est compensée par le fait que les transistors suiveurs Q8 et Q9, les sources de polarisation correspondantes, et les résistances d'émetteur de la figure 1 sont omis. L'augmentation de taille entraîne une augmentation de la capacité de grille des transistors MOS. Toutefois, la perte de rapidité qui peut en résulter est compensée en augmentant le courant de polarisation des étages à transistors MOS, cette augmentation de courant n'étant pas gênante puisque de nombreuses sources de polarisation (Q12, Q13) ont été omises, et qu'elle contribue en outre à augmenter la transconductance des transistors MOS.

Il ne convient pas de remplacer les transistors Q1 à Q4 par des transistors MOS car, si la tension Vcc est choisie à sa valeur minimale, la tension grille-source maximale de ces transistors MOS serait de l'ordre de Vbe+Vs qui dépasse à peine la tension seuil Vt d'un transistor MOS. Un transistor MOS serait à peine rendu conducteur et ne pourrait que partiellement aiguiller le courant de l'étage différentiel vers sa branche correspondante. Au contraire, la valeur Vbe+Vs est nettement suffisante pour rendre entièrement passant un transistor bipolaire.

Bien entendu, la présente invention n'est pas limitée au circuit multiplexeur de la figure 2 qui ne représente qu'un exemple.

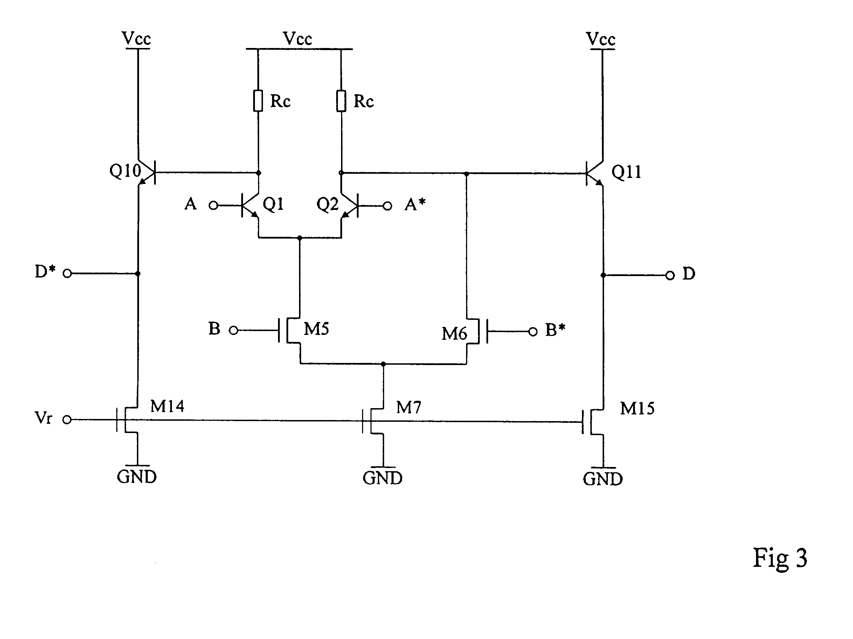

La figure 3 illustre un autre exemple de circuit logique selon l'invention, ici une porte ET (ou NON ET selon que l'on intervertit les sorties D/D* ou non). Un premier signal différentiel A/A* est appliqué aux entrées d'un étage constitué de transistors Q1 et Q2 connectés comme les transistors Q1 et Q2 de la figure 2 à des résistances de collecteur Rc et à des transistors de sortie Q10 et Q11. L'étage Q1, Q2 est monté dans une branche d'un étage différentiel à transistors MOS M5 et M6, dont l'autre branche (drain du transistor M6) est reliée au collecteur du transistor Q2. Cet étage M5, M6 reçoit un signal différentiel B/B* et est polarisé par un transistor MOS M7 comme l'étage M5, M6 de la figure 2.

**Revendications**

1. Circuit logique comprenant au moins un premier étage différentiel (Q1, Q2) réalisé à partir de transistors bipolaires fonctionnant en régime linéaire, monté dans une branche d'un deuxième étage différentiel (M5, M6) polarisé par une source de courant (M7), le deuxième étage et la source de courant étant réalisés à partir de transistors MOS, caractérisé en ce que les transistors MOS du deuxième étage reçoivent sur leurs grilles les mêmes niveaux de tension que les bases des transistors bipolaires du premier étage.

2. Circuit logique selon la revendication 1, caractérisé en ce que les grilles des transistors MOS du deuxième étage (M5, M6) constituent directement des entrées du circuit logique.

3. Circuit logique selon la revendication 1, caractérisé en ce que la source de courant est réalisée à partir d'un transistor MOS (M7) dont la source est directement reliée à un potentiel d'alimentation (GND).

4. Circuit logique selon la revendication 1, utilisé comme multiplexeur, caractérisé en ce qu'il comprend deux premiers étages (Q1-Q4) dont les branches correspondantes sont reliées entre elles, ces deux étages étant respectivement montés dans les branches du deuxième étage (M5, M6).

5. Circuit logique selon la revendication 1, utilisé comme porte logique, caractérisée en ce qu'elle comprend un premier étage (Q1, Q2) monté dans une première branche du deuxième étage (M5, M6), la deuxième branche du deuxième étage étant reliée à une branche du premier étage.

6. Circuit logique selon l'une quelconque des revendications 1 à 5, caractérisé en ce que les transistors bipolaires sont de type NPN et les transistors MOS sont à canal N.

## Patentansprüche

1. Logische Schaltung, welche wenigstens eine mit in linearem Betrieb arbeitenden Bipolartransistoren ausgebildete erste Differenzstufe (Q1,Q2) in Anordnung in einem Zweig eine durch eine Stromquelle (M7) vorgespannten zweiten Differenzst (M5,M6) aufweist, wobei die zweite Stufe und die Stromquelle mit MOS-Transistoren ausgebildet sind, **dadurch gekennzeichnet**, daß an den Gate-Anschlüssen der MOS Transistoren der zweiten Stufe dieselben Spannungspegel angelegt sind wie an den Basisanschlüssen der Bipolartransistoren der ersten Stufe.

2. Logische Schaltung nach Anspruch 1, dadurch gekennzeichnet, daß die Gate-Anschlüsse der MOS-Transistoren der zw ten Stufe (M5,M6) unmittelbar Eingänge der logischen Schaltun bilden.

3. Logische Schaltung nach Anspruch 1, dadurch gekennzeichnet, daß die Stromquelle mit einem MOS-Transistor (M7) a gebildet ist, dessen Source-Anschluß direkt mit einem Speisepotential (GND) verbunden ist.

4. Logische Schaltung nach Anspruch 1, zur Verwendung als Multiplexer, dadurch gekennzeichnet, daß sie zwei erste Stufen (Q1-Q4) aufweist, deren entsprechenden Zweige miteinander verbunden sind, wobei diese beiden Stufen jeweils entsprechend in den Zweigen der zweiten Stufe (M5,M6) angeordnet sind.

5. Logische Schaltung nach Anspruch 1, zur Verwendung als logische Torschaltung, dadurch gekennzeichnet, daß sie eine in einem ersten Zweig der zweiten Stufe (M5,M6) angeordnete erste Stufe (Q1,Q2) aufweist, und daß der zweite Zweig der zweiten Stufe mit einem Zweig der ersten Stufe verbunden ist.

6. Logische Schaltung nach einem der Ansprüche 1 bis 5, dadurch gekennzeichnet, daß die Bipolartransistoren vom NPN-Typ und die MOS-Transistoren N-Kanaltransistoren sind.

## Claims

1. A logic circuit comprising at least one first differential stage (Q1, Q2) achieved from bipolar transistors operating in linear mode, connected in a second differential stage (M5, M6) biased by a current source (M7), the second stage and the current source being achieved from MOS transistors, in the gates of the MOS transistors of the second stage receive the same voltage levels as the bases of the bipolar transistors of the first stage.

2. The logic circuit of claim 1, wherein the gates of the MOS transistors of the second stage (M5, M6) directly constitute inputs of the logic circuit.

3. The logic circuit of claim 1, wherein the current source comprises a MOS transistor (M7) whose source is directly connected to a supply voltage (GND).

4. The logic circuit according to claim 1 used as a multiplexer, comprising two first stages (Q1-Q4) whose corresponding branches are interconnected, said two stages being respectively connected in the branches of the second stage (M5, M6).

5. The logic circuit according to claim 1 used as a logic gate, including a first stage (Q1, Q2) connected to a first branch of the second stage (M5, M6), the second branch of the second stage being connected to a branch of the first stage.

6. A logic circuit according to any of claims 1 to 5, wherein the bipolar transistors are NPN transistors and the MOS transistors are N-channel transistors.

Fig 1

Fig 2

Fig 3

EP 0 700 162 B1